# EUROPEAN PATENT APPLICATION

(11) **EP 4 746 639 A1**
(43) Date of publication of application: **20.05.2026**
(21) Application number: 24916232.2
(22) Date of filing: 01.04.2024
(51) Int. Cl.: H10F 19/90, H10F 77/20

(54) **BATTERY STRING, BATTERY ASSEMBLY, AND PHOTOVOLTAIC SYSTEM**

(30) Priority: 09.01.2024 CN 202420053311 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/085306
(87) International publication number: WO 2025/148174

(57) **Abstract**

The present disclosure is applicable to the technical field of solar cells, and provides a battery string (100), a battery assembly (200), and a photovoltaic system (1000). In the battery string (100), first fingers (11) are connected with first busbars (13) and are disconnected at a position where second busbars (14) is provided, and second fingers (12) are connected with the second busbars (14) and are disconnected at a position where the first busbars (13) is provided; and the first ribbon (20) is connected with the first busbars (13) in one back-contact solar cells (10) of the two adjacent back-contact solar cells and the second busbars (14) in an other back-contact solar cells (10) of the two adjacent back-contact solar cells, and the second ribbon (30) is connected with the second busbars (14) in one back-contact solar cells (10) of the two adjacent back-contact solar cells and the first busbars (13) in the other back-contact solar cells (10) of the two adjacent back-contact solar cells. There are first gaps (111) between the second busbars (13) and disconnection point formed by disconnecting the first fingers (12), and there are second gaps (121) between the first busbars (13) and disconnection point formed by disconnecting the second fingers (12). At a position corresponding to a spacer region (101) between two back-contact solar cells (10), the first ribbon (20) forms a first suspended segment (21) at the spacer region (101), or the second ribbon (30) forms a second suspended segment (31) at the spacer region (101), and a length of the second suspended segment (21) and a length of the second suspended segment (31) are both less than a width (L1) of the first gap (111) and a width (L2) of the second gap (121).

## Description

### Priority Information

The present disclosure claims the priority and benefits of Patent Application 202420053311.3, filed in the China National Intellectual Property Administration on January 09, 2024, and the entire contents of which are herein incorporated by reference.

### Technical Field

The present disclosure relates to the technical field of solar cells, and in particular to a battery string, a battery assembly, and a photovoltaic system.

### Background

In the related art, a back surface of a back-contact cell is usually provided with fingers and busbars, when a battery string is formed, the busbars with different polarities of two adjacent battery cells are aligned, then ribbons are welded on the busbars to connect the two battery cells in series, and one ribbon is cut off every other ribbon to form a complete battery string.

However, in such a technical solution, since the ribbons is cut off, a portion of which is suspended, and the suspended portion is likely to bend to make contact with the finger having a polarity different from that of the ribbon, resulting in a short circuit.

### Summary

The present disclosure provides a battery string, a battery assembly, and a photovoltaic system.

The present disclosure is implemented in such a way that the battery string in an embodiment of the present disclosure includes:
several back-contact solar cells arranged at intervals in a first direction, wherein each back-contact solar cell includes several first fingers, several second fingers, several first busbars and several second busbars, the first finger and the second finger are sequentially and alternately disposed in parallel at intervals in the first direction, the first busbar and the second busbar are sequentially and alternately arranged in parallel at intervals in a second direction, the first direction intersects with the second direction, the first fingers are connected with the first busbars and are disconnected at a position where the second busbars is provided, and the second fingers are connected with the second busbars and are disconnected at a position where the first busbars is provided; in two adjacent back-contact solar cells, the first busbars of one back-contact solar cell correspond to the second busbars of an other back-contact solar cell in the first direction, and spacer regions are provided between two adjacent back-contact solar cells; and
several first ribbons and several second ribbons, wherein the first ribbon and the second ribbon are sequentially and alternately arranged at intervals in the second direction, wherein the first ribbons and the second ribbons are parallel to the first busbars and the second busbars and are correspondingly disposed on the first busbars and the second busbars; the first ribbon is connected with the first busbars in one back-contact solar cell of the two adjacent back-contact solar cells and the second busbars in an other back-contact solar cell of the two adjacent back-contact solar cells, and the second ribbons are connected with the second busbars in one back-contact solar cells of the two adjacent back-contact solar cells and the first busbars in the other back-contact solar cells of the two adjacent back-contact solar cells;
in the second direction, there are first gaps between the second busbars and disconnection point formed by disconnecting the first fingers, and there are second gaps between the first busbars and disconnection point formed by disconnecting the second fingers;
at a position corresponding to each spacer region, the first ribbon or the second ribbon is cut off, in a case where the first ribbon is cut off, the first ribbon forms a first suspended segment at the spacer region, and a length of the first suspended segment is less than a width of the first gap and a width of the second gap; and
in a case where the second ribbon is cut off, the second ribbon forms a second suspended segment at the spacer region, and a length of the second suspended segment is less than the width of the first gap and the width of the second gap.

Further, a number of the back-contact solar cells is greater than two, in two adjacent spacer regions, the first ribbon in one spacer region is cut off, and the second ribbon in an other spacer region is cut off.

Further, the width of the first gap ranges from 0.9mm to 1.2mm; and the width of the second gap ranges from 0.9mm to 1.2mm.

Further, in the first direction, a distance between two adjacent back-contact solar cells ranges from 0.3mm to 1.2mm.

Further, the width of the first gap is greater than the width of the second gap.

Further, at the position corresponding to each spacer region, a side of the first ribbon facing a light-receiving surface of the back-contact solar cell is provided with a first shielding layer, and
a side of the second ribbon facing the light-receiving surface of the back-contact solar cell is provided with a second shielding layer.

Further, a color of the first shielding layer and a color of the second shielding layer correspond to a color of the back-contact solar cell.

Further, an end portion of the first suspended segment and an end portion of the second suspended segment are coated with insulating coatings, and the insulating coatings wrap the end portion of the first suspended segment and the end portion of the second suspended segment.

Further, a color of the insulating coating corresponds to the color of the back-contact solar cell.

The present disclosure further provides a battery assembly, including several battery strings mentioned above.

The present disclosure further provides a photovoltaic system, including the battery assembly mentioned above.

Additional aspects and advantages of the present disclosure will be given in part in the following description, become apparent in part from the following description, or be learned from the practice of the present disclosure.

### Brief Description of the Drawings

Fig. 1 is a schematic diagram of modules of a photovoltaic system provided in an embodiment of the present disclosure;
Fig. 2 is a schematic diagram of modules of a battery assembly provided in an embodiment of the present disclosure;
Fig. 3 is a schematic diagram of a planar structure of a battery string provided in an embodiment of the present disclosure;
Fig. 4 is a schematic diagram of another planar structure of a battery string provided in an embodiment of the present disclosure;
Fig. 5 is a schematic diagram of yet another planar structure of a battery string provided in an embodiment of the present disclosure;
Fig. 6 is a schematic sectional view of the battery string in Fig. 5 in a first direction at the position of a first ribbon;
Fig. 7 is a schematic sectional view of the battery string in Fig. 5 in the first direction at the position of a second ribbon;
Fig. 8 is a schematic sectional view of the battery string in Fig. 3 in the first direction at the position of the first ribbon; and
Fig. 9 is a schematic sectional view of the battery string in Fig. 3 in the first direction at the position of the second ribbon.

Description of Main Element Symbols:
photovoltaic system 1000, battery assembly 200, battery string 100, back-contact solar cell 10, first finger 11, second finger 12, first busbar 13, second busbar 14, first ribbon 20, first suspended segment 21, second ribbon 30, second suspended segment 31, first bus bar 40, second busbar 50, first shielding layer 60, second shielding layer 70, and insulating coating 80.

### Detailed Description of the Embodiments

To make the objectives, technical solutions and advantages of the present disclosure clearer, the present disclosure will be further described in detail below in combination with the drawings and embodiments. Examples of the embodiments are shown in the drawings, wherein the same or similar reference signs represent the same or similar elements or elements having the same or similar functions throughout. It should be noted that the embodiments described below with reference to the drawings are exemplary, are merely used to explain the present disclosure, but cannot be construed as limiting the present disclosure. In addition, it should be understood that specific embodiments described herein are only used to explain the present disclosure and are not intended to limit the present disclosure.

In the description of the present disclosure, it should be understood that orientation or position relationships indicated by terms "upper", "lower", "left", "right", "transverse", "longitudinal" and the like are orientation or position relationships shown based on the drawings, and are merely for the convenience of describing the present disclosure and simplifying the description, but do not indicate or imply that referred apparatuses or elements must have specific orientations or must be constructed and operated in specific orientations, and thus cannot be construed as limitations to the present disclosure.

**In** addition, the terms "first", "second" and the like are used for descriptive purposes only and cannot be understood as indicating or implying relative importance or implicitly indicating the number of indicated technical features. Thus, features defined with "first" and "second" can explicitly or implicitly include one or more of the features. In the description of the present disclosure, "several" means two or more, unless specifically defined otherwise.

**In** the present disclosure, unless otherwise specified and limited, a first feature being "on" or "under" a second feature can include that the first feature and the second feature are in direct contact with each other, or the first feature and the second feature are not in direct contact with each other but are in in contact through an additional feature therebetween. Moreover, the first feature being "over", "above" and "on" the second feature includes that the first feature is directly above or obliquely above the second feature, or merely indicates that a horizontal height of the first feature is greater than that of the second feature. The first feature being "under", "below" and "beneath" the second feature includes that the first feature is directly below or obliquely below the second feature, or merely indicates that the horizontal height of the first feature is less than that of the second feature.

The following disclosure provides many different embodiments or examples for implementing different structures of the present disclosure. In order to simplify the disclosure of the present disclosure, components and settings of specific examples are described below. Of course, they are merely examples, and are not intended to limit the present disclosure. In addition, the present disclosure can repeat reference numerals and/or reference letters in different examples, and this repetition is for the purpose of simplicity and clarity, and does not indicate the relationship between various embodiments and/or settings discussed in itself. In addition, the present disclosure provides examples of various particular processes and materials, but those ordinary skilled in the art can be aware of disclosures of other processes and/or use scenarios of other materials.

### Embodiment 1

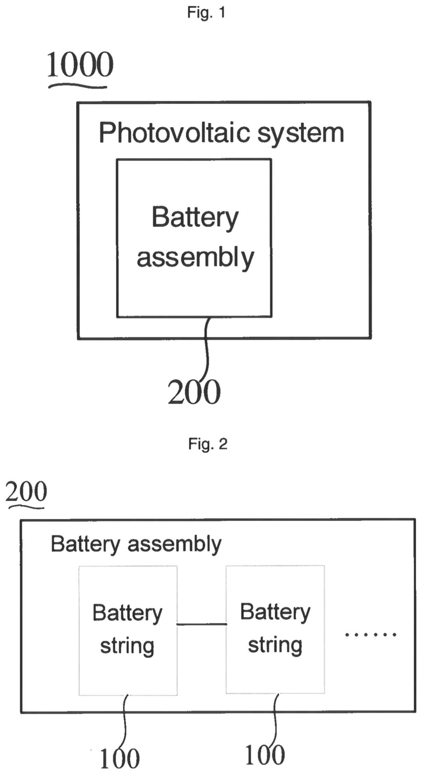

Referring to Fig. 1 and Fig. 2, a photovoltaic system 1000 in the embodiment of the present disclosure can include a battery assembly 200 in the embodiment of the present disclosure, and the battery assembly 200 in the embodiment of the present disclosure can include several battery strings 100 in the embodiment of the present disclosure.

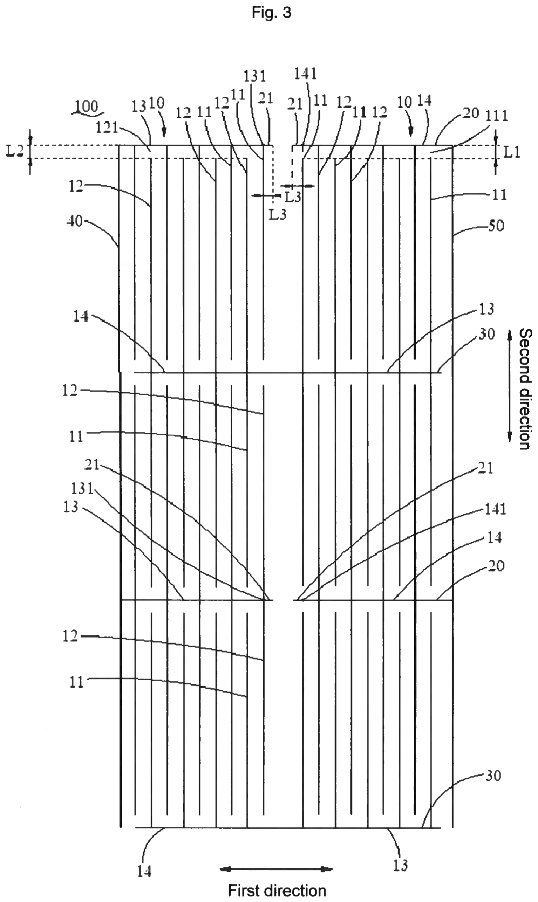

Referring to Fig. 3 to Fig. 6, the battery string 100 in the embodiment of the present disclosure can include several back-contact solar cells 10, several first ribbons 20, and several second ribbons 30.

The several back-contact solar cells 10 can be arranged at intervals in a first direction, and a rear side of each back-contact solar cell 10 includes several first fingers 11, several second fingers 12, several first busbars 13 and several second busbars 14.

As shown in Fig. 3 to Fig. 5, the first finger 11 and the second finger 12 are sequentially and alternately disposed in parallel at intervals in the first direction, the first busbar 13 and the second busbar 14 are sequentially and alternately arranged in parallel at intervals in a second direction, and the first direction intersects with the second direction. The first direction can be a serial connection direction (that is, a transverse direction in Fig. 3) of the battery string 100, and the second direction can be a direction perpendicular to the serial connection direction (that is, a longitudinal direction in Fig. 3), and the two directions are perpendicular to each other.

The first fingers 11 and the second fingers 12 are disposed corresponding to first doped layers (not shown in the figure) of the back-contact solar cell 10, the second fingers 12 are disposed corresponding to second doped layers (not shown in the figure) of the back-contact solar cell 10, one of the first doped layer and the second doped layer is a P-type doped layer, and the other is an N-type doped layer.

As shown in Fig. 3 to Fig. 5, in the back-contact solar cell 10, the first fingers 11 are connected with the first busbars 13 and are disconnected at a position where the second busbars 14 is provided, and the second fingers 12 are connected with the second busbars 14 and are disconnected at a position where the first busbars 13 is provided.

In two adjacent back-contact solar cells 10, the first busbars 13 of one back-contact solar cell 10 correspond to the second busbars 14 of the other back-contact solar cell 10 in the first direction (that is, as shown in Fig. 3 to Fig. 5, the first busbars 13 and the second busbars 14 of two adjacent back-contact solar cells 10 are basically located on the same straight line), and spacer regions 101 are provided between two adjacent back-contact solar cells.

The several first ribbons 20 and the several second ribbons 30, wherein the first ribbon and the second ribbon are sequentially and alternately arranged at intervals in the second direction, the first ribbons 20 and the second ribbons 30 are parallel to the first busbars 13 and the second busbars 14 and are correspondingly disposed above the first busbars 13 and the second busbars 14 (that is, as shown in Fig. 3 to Fig. 5, the first ribbons 20 and the second ribbons 30 are aligned and overlap with the first busbars 13 and the second busbars 14), the first ribbon 20 is connected with the first busbars 13 in one back-contact solar cells 10 of the two adjacent back-contact solar cells and the second busbars 14 in an other back-contact solar cells 10 of the two adjacent back-contact solar cells, and the second ribbon 30 is connected with the second busbars 14 in one back-contact solar cells 10 of the two adjacent back-contact solar cells and the first busbars 13 in the other back-contact solar cells 10 of the two adjacent back-contact solar cells.

Specifically, as shown in Fig. 3 to Fig. 5, each first ribbon 20 is sequentially and alternately connected with several first busbars 13 and several second busbars 14 in the first direction, and similarly, each second ribbon 30 is sequentially and alternately connected with several second busbars 14 and several first busbars 13 in the first direction. That is, in the first direction, each first ribbon 20 is connected in parallel with the first busbars 13 of an Nth back-contact solar cell and the second busbars 14 of an (N+1)th back-contact solar cell, and each second ribbon 20 is connected in parallel with the second busbars 14 of the Nth back-contact solar cell and the first busbars 13 of the (N+1)th back-contact solar cell.

As shown in Fig. 3 to Fig. 4, in the second direction, there are first gaps 111 between the second busbars 14 and disconnection point formed by disconnecting the first fingers 11, a width of the first gap 111 is L1 in Fig. 3 to Fig. 6, there are second gaps 121 between the first busbars 13 and disconnection point formed by disconnecting the second fingers 12, and a width of the second gap 121 is L2 in Fig. 3 to Fig. 6.

At a position corresponding to each spacer region 101, the first ribbon 20 or the second ribbon 30 is cut off. As shown in Fig. 3, in a case where the first ribbon 20 is cut off, the first ribbon 20 forms a first suspended segment 21 at the spacer region 101, and a length L3 of the first suspended segment 21 is less than the width L1 of the first gap 111 and the width L2 of the second gap 121.

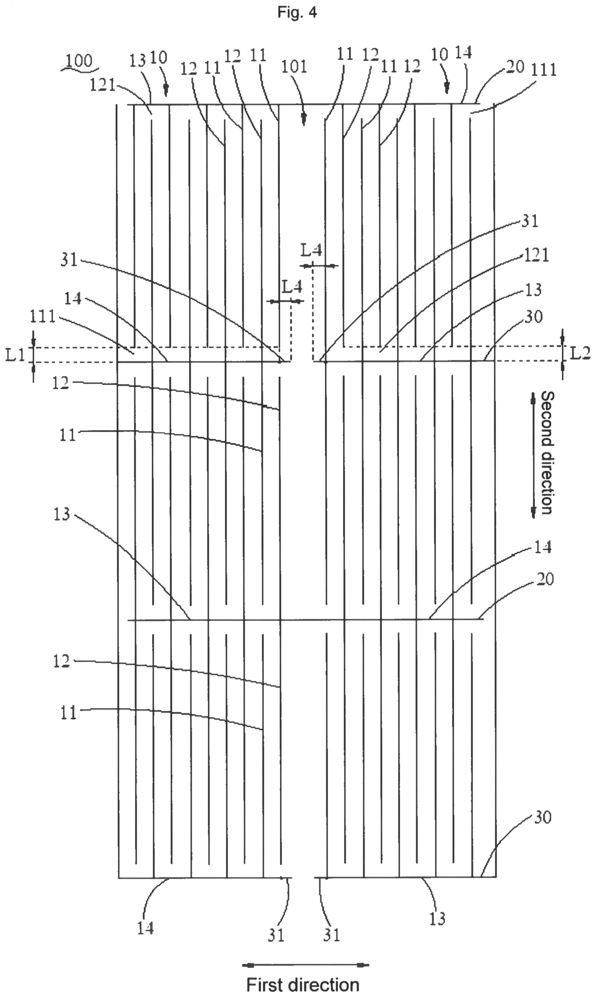

As shown in Fig. 4, in a case where the second ribbon 30 is cut off, the second ribbon 30 forms a second suspended segment 31 at the spacer region 101, and a length L4 of the second suspended segment 31 is less than the width L1 of the first gap 111 and the width L2 of the second gap 121.

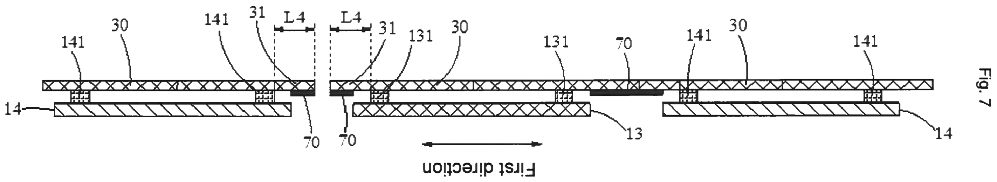

Referring to Fig. 7, in the present disclosure, several first solder joints 131 are disposed on the first busbars 13, several second solder joints 141 are disposed on the second busbars 14, and the first ribbons 20 and the second ribbons 30 are connected with the first busbars 13 and the second busbars 14 through the first solder joints 131 and the second solder joints 141.

It should be noted that, as shown in Fig. 3, the cut off first ribbon 20 forms two end points, which form two first suspended segments 21, one first suspended segment 21 is connected with the first busbar 13, and the other first suspended segment 21 is connected with the second busbar 14.

The first suspended segment 21 connected with the first busbar 13 refers to a portion, which is formed during cut off, between an end point close to the first busbar 13 and the first solder joint 131 closest to the spacer region 101 on the first busbar 13, the length L3 of the first suspended segment 21 is a distance between the end point close to the first busbar 13 and the first solder joint 131 closest to the spacer region 101 on the first busbar 13, the first suspended segment 21 connected with the second busbar 14 refers to a portion, which is formed during cut off, between an end point close to the second busbar 14 and the second solder joint 141 closest to the spacer region 101 on the second busbar 14, and the length L3 of the first suspended segment 21 is a distance between the end point close to the second busbar 14 and the second solder joint 141 closest to the spacer region 101 on the second busbar 14.

Similarly, as shown in Fig. 4, the cut off second ribbon 30 also forms two end points, which form two second suspended segments 31, one second suspended segment 31 is connected with the second busbar 14, and the other second suspended segment 31 is connected with the first busbar 13.

The second suspended segment 31 connected with the first busbar 13 refers to a portion, which is formed during cut off, between an end point close to the first busbar 13 and the first solder joint 131 closest to the spacer region 101 on the first busbar 13, the length L4 of the second suspended segment 31 is a distance between the end point close to the first busbar 13 and the first solder joint 131 closest to the spacer region 101 on the first busbar 13, the second suspended segment 31 connected with the second busbar 14 refers to a portion, which is formed during cut off, between an end point close to the second busbar 14 and the second solder joint 141 closest to the spacer region 101 on the second busbar 14, and the length L4 of the second suspended segment 31 is a distance between the end point close to the second busbar 14 and the second solder joint 141 closest to the spacer region 101 on the second busbar 14.

In the battery string 100, the battery assembly 200 and the photovoltaic system 1000 in the embodiment of the present disclosure, the first ribbons 20 are connected with the first busbars 13 in the previous back-contact solar cells 10 and the second busbars 14 in the latter back-contact solar cells 10, and the second ribbons 30 are connected with the second busbars 14 in the previous back-contact solar cells 10 and the first busbars 13 in the latter back-contact solar cells 10. In the second direction, there are the first gaps 111 between the second busbars 14 and the disconnection points formed by disconnecting the first fingers 11, and there are the second gaps 121 between the first busbars 13 and the disconnection points formed by disconnecting the second fingers 12. At the position corresponding to each spacer region 101, the first ribbon 20 or the second ribbon 30 is cut off, in a case where the first ribbon 20 is cut off, the first ribbon 20 forms the first suspended segment 21 at the spacer region 101, and the length L3 of the first suspended segment 21 is less than the width L1 of the first gap 111 and the width L2 of the second gap 121 (that is, L3<L1 and L3 <L2). In a case where the second ribbon 30 is cut off, the second ribbon 30 forms the second suspended segment 31 at the spacer region 101, and the length L4 of the second suspended segment 31 is less than the width L1 of the first gap 111. Thus, during a process of forming a battery string, by controlling the length L3 of the first suspended segment 21 to be less than the width L1 of the first gap 111 and controlling the length L4 of the second suspended segment 31 to be less than the width L1 of the first gap 111 and the width L2 of the second gap 121 (that is, L4<L1 and L4< L2), it can be ensured that the first suspended segment 21 does not make contact with the second finger 12 when bending, and it can also be ensured that the second suspended segment 31 does not make contact with the first finger 11 when bending, thereby avoiding the occurrence of a short circuit and ensuring the stability and reliability of the battery string.

As shown in Fig. 3 and Fig. 4, in the embodiment of the present disclosure, the battery string 100 further includes a first bus bar 40 and a second bus bar 50, which are respectively located on two ends of the battery string 100, the first bus bar 40 can be connected with all the second ribbons 30, and the second bus bar 50 can be connected with all the first ribbons 20, so as to implement confluence output of the battery string 100.

It is not difficult to understand that, as shown in Fig. 3 and Fig. 4, in a possible embodiment, if the battery string has only two back-contact solar cells 10, there is only one spacer region 101 in the battery string, and in the spacer region 101, the first ribbon 20 is cut off (shown in Fig. 3), or the second ribbon 30 is cut off (as shown in Fig. 4).

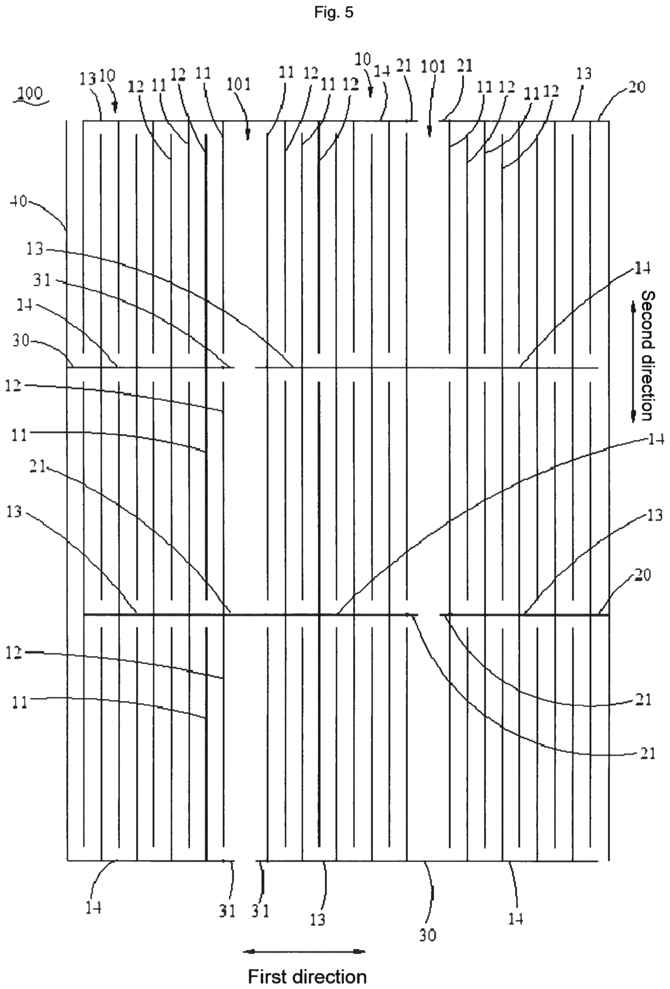

Referring to Fig. 5, in some embodiments, a number of the back-contact solar cells 10 can be greater than two, in this case, in two adjacent spacer regions 101, the first ribbon 20 in one spacer region 101 is cut off, and the second ribbon 30 in an other spacer region 101 is cut off.

Thus, if the number of the back-contact solar cells 10 in the battery string 100 exceeds two, in the two adjacent spacer regions 101, the cut off ribbons are different, and accordingly smooth collection and transmission of the current can be realized to avoid a short circuit.

Specifically, in this case, if the first ribbon 20 in an Nth spacer region 101 is cut off, then the second ribbon 30 in an (N+1)th spacer region 101 is cut off, and N is a positive integer.

In some embodiments, the width L1 of the first gap 111 can be greater than the width L2 of the second gap 121, that is, L2>L1. Thus, an accidental contact between the first fingers 11 and the second busbars 13 can be effectively avoided, for example, when the width of the second ribbon 30 is greater than the width of the first ribbon 20, the width L1 of the first gap 111 can be set to be greater to avoid the contact between the first fingers 11 and the second busbars 13.

It can be understood that, in the embodiment of the present disclosure, the battery assembly 200 can further include a metal frame, a backsheet, photovoltaic glass, and adhesive films (not shown in the figures). The adhesive films can be filled between a front surface of the back-contact solar cell 10 and the photovoltaic glass, a back surface of the back-contact solar cell and the backsheet, and between adjacent battery cells to serve as fillers, which can be transparent colloid having good light transmittance and aging resistance, for example, in some embodiments, the adhesive film is an EVA adhesive film, in some embodiments, the adhesive film is a POE adhesive film, which can be specifically selected according to actual situations, which is not limited herein.

The photovoltaic glass can cover the adhesive film on the front surface of the back-contact solar cell 10, the photovoltaic glass can be ultra-white glass, which has high light transmittance and high transparency, and has excellent physical, mechanical and optical properties, for example, the light transmittance of the ultra-white glass can reach more than 92%, and thus the ultra-white glass can protect the back-contact solar cell 10 without affecting the efficiency of the back-contact solar cell 10 as much as possible. Meanwhile, the adhesive film can bond the photovoltaic glass and the back-contact solar cell 10 together, therefore due to the presence of the adhesive film, sealing insulation and water and moisture resistance can be performed on the back-contact solar cell 10.

The backsheet can be attached to the adhesive film on the back surface of the back-contact solar cell 10, the backsheet can protect and support the back-contact solar cell 10 and has reliable insulativity, water resistance and aging resistance, the backsheet can have multiple choices, can be tempered glass, acrylic glass, an aluminum alloy TPT composite adhesive film and the like in general, and can be specifically set according to specific situations, which is not limited herein. An entirety formed by the backsheet, the back-contact solar cell 10, the adhesive film and the photovoltaic glass can be disposed on the metal frame, the metal frame serves as a main external supporting structure of the whole battery assembly 200 and can provide stable support and installation for the battery assembly 200, for example, the battery assembly 200 can be installed at a required position through the metal frame.

Further, in some embodiments, the photovoltaic system 1000 is applied to photovoltaic power stations, for example, surface power stations, roof power stations, water-surface power stations, and the like, in some embodiments, the photovoltaic system 1000 is also applied to devices or apparatuses for generating power by using solar energy, for example, user solar power supplies, solar street lamps, solar vehicles, solar buildings, and the like. Of course, it can be understood that the application scenarios of the photovoltaic system 1000 are not limited thereto, that is, the photovoltaic system 1000 can be applied to all fields in which power generation needs to be performed by using solar energy. Taking a photovoltaic power generation system network as an embodiment, the photovoltaic system 1000 can include a photovoltaic array, a combiner box and an inverter, the photovoltaic array can be an array combination of a plurality of battery assemblies 200, for example, the plurality of battery assemblies 200 can form a plurality of photovoltaic arrays, the photovoltaic array is connected with the combiner box, the combiner box can converge current generated by the photovoltaic array, and the converged current flows through the inverter to be converted into alternating current required by a mains power grid, and then the alternating current is connected to a mains supply network to implement solar power supply.

### Embodiment 2

In some embodiments, the width L1 of the first gap 111 can range from 0.9mm to 1.2mm, and the width L2 of the second gap 121 can range from 0.9mm to 1.2mm.

Thus, it is possible to avoid the situation in which the length L3 of the first suspended segment 21 and the length L4 of the second suspended segment 31 need to be set smaller due to the fact that the width L1 of the first gap 111 and the width L2 of the second gap 121 adjacent to each other are too small, such that the process difficulty is increased when the first ribbons 20 and the second ribbons 30 are cut off; and it also possible to avoid the situation in which the area proportion of the back-contact solar cells 20 without first fine gates 11 and second fine gates 12 in the back-contact solar cell 20 is reduced due to the fact that the width L1 of the first gap 111 and the width L2 of the second gap 121 are too large, such that the efficiency of the back-contact solar cells 10 is reduced.

Specifically, in such an embodiment, the width L1 of the first gap 111 can be, for example, 0.9mm, 0.95mm, 1mm, 1.05mm, 1.1mm, 1.15mm, 1.2mm or any value between 0.9mm and 1.2mm, which is not specifically limited herein. The width L2 of the second gap 121 can be, for example, 0.9mm, 0.95mm, 1mm, 1.05mm, 1.1mm, 1.15mm, 1.2mm or any value between 0.9mm and 1.2mm, which is not specifically limited herein. The width L1 of the first gap 111 can be the same as or different from the width of the second gap 121, which is not specifically limited herein.

### Embodiment 3

In some embodiments, in the first direction, a distance between two adjacent back-contact solar cells 10 (i.e., the width of the spacer region 101 in the first direction) can range from 0.3 mm to 1.2 mm.

Thus, it is possible to avoid the situation in which it is inconvenient to cut off the first ribbons 20 and the second ribbons 30 or the back-contact solar cells 10 are damaged due to the fact that the distance between the two adjacent back-contact solar cells 10 is too small; and it is also possible to avoid the situation in which the number of back-contact solar cells 10 in a single battery string 100 under the same size is reduced and the length of the first suspended segment 21 and the length of the second suspended segment 31 are too long due to the fact that the distance between the two adjacent back-contact solar cells 10 is too large.

Specifically, in such an embodiment, the distance between the two adjacent back-contact solar cells 10 can be, for example, 0.3mm, 0.4mm, 0.5mm, 0.6mm, 0.7mm, 0.8mm, 0.9mm, 1mm, 1.1mm, 1.2mm, or any value between 0.3mm and 1.2 mm, which is not specifically limited herein.

### Embodiment 4

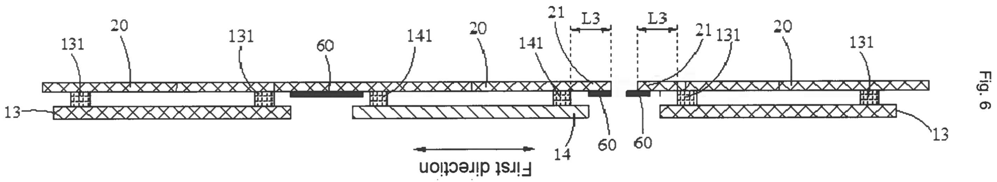

Referring to Fig. 6 and Fig. 7, in some embodiments, at the position corresponding to each spacer region 101, a side of the first ribbon 20 facing a light-receiving surface (i.e., a bottom surface in Fig. 6 and Fig. 7) of the back-contact solar cell 10 is provided with a first shielding layer 60. A side of the second ribbon 30 facing the light-receiving surface of the back-contact solar cell 10 is provided with a second shielding layer 70.

Thus, by coating the first shielding layer 60 at a region where the first ribbon 20 is exposed from the spacer region 101, and coating the second shielding layer 70 at a region where the second ribbon 30 is exposed from the spacer region 101, the first ribbon 20 and the second ribbon 30 can be shielded, thereby avoiding an impact on the beautiful appearance due to the direct exposure of the first ribbon 20 and the second ribbon 30.

Further, in some embodiments, a color of the first shielding layer 60 and a color of the second shielding layer 70 correspond to a color of the back-contact solar cell 10. For example, when the back-contact solar cell 10 is blue, the color of the first shielding layer 60 and the color of the second shielding layer 70 can also be blue, and when the back-contact solar cell 10 is golden, the color of the first shielding layer 60 and the color of the second shielding layer 70 can also be golden.

Thus, the color of an exposed position of the first ribbon 20 and the color of an exposed position of the second ribbon 30 can be the same as the color of the back-contact solar cell, so as to avoid seeing the first ribbon 20 and the second ribbon 30 of different colors from the front surface at the spacer region 101, thus ensuring the esthetic feeling of the appearance.

### Embodiment 5

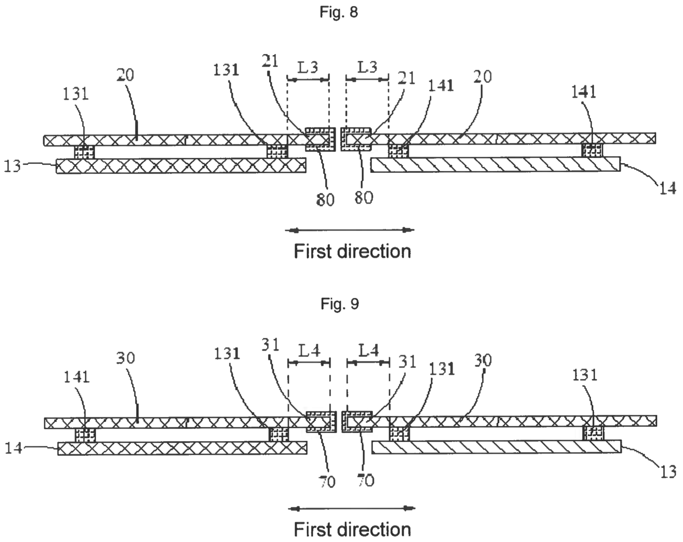

Referring to Fig. 8 and Fig. 9, in some embodiments, an end portion of the first suspended segment 21 and an end portion of the second suspended segment 31 are coated with insulating coatings 80, and the insulating coatings 80 wrap the end portion of the first suspended segment 21 and the end portion of the second suspended segment 31.

Thus, by disposing the insulating coatings 80, a conductive contact between the two end portions due to an accident after the first ribbon 20 and the second ribbon 30 are cut off can be avoided, thereby improving the reliability of the battery string 100.

Further, in some embodiments, a color of the insulating coating 80 can correspond to the color of the back-contact solar cell 10. Thus, the esthetic feeling of the appearance of the entire battery string 100 can be ensured.

In the description of the present specification, description with reference to the terms "some embodiments", "an exemplary embodiment", "an example", "a specific example" or "some examples" means that particular features, structures, materials or characteristics described in combination with the embodiment or example are included in at least one embodiment or example of the present application. In the present specification, the schematic representation of the above terms does not necessarily refer to the same embodiment or example. Furthermore, the particular features, structures, materials or characteristics described may be combined in any suitable manner in one or more embodiments or examples.

In addition, the above descriptions are merely preferred embodiments of the present disclosure and are not intended to limit the present disclosure, and any modifications, equivalent replacements, improvements, and the like, made within the spirit and principles of the present disclosure, shall fall within the protection scope of the present disclosure.

## Claims

1. A battery string, comprising:
several back-contact solar cells arranged at intervals in a first direction, wherein each back-contact solar cell comprises several first fingers, several second fingers, several first busbars and several second busbars, the first finger and the second finger are sequentially and alternately disposed in parallel at intervals in the first direction, the first busbar and the second busbar are sequentially and alternately arranged in parallel at intervals in a second direction, the first direction intersects with the second direction, the first fingers are connected with the first busbars and are disconnected at a position where the second busbars is provided, and the second fingers are connected with the second busbars and are disconnected at a position where the first busbars is provided; in two adjacent back-contact solar cells, the first busbars of one back-contact solar cell correspond to the second busbars of an other back-contact solar cell in the first direction, and spacer region are provided between two adjacent back-contact solar cells; and
several first ribbons and several second ribbons, wherein the first ribbon and the second ribbon are sequentially and alternately arranged at intervals in the second direction, wherein the first ribbons and the second ribbons are parallel to the first busbars and the second busbars and are correspondingly disposed on the first busbars and the second busbars; the first ribbon is connected with the first busbars in one back-contact solar cell of the two adjacent back-contact solar cells and the second busbars in an other back-contact solar cell of the two adjacent back-contact solar cells, and the second ribbon is connected with the second busbars in one back-contact solar cells of the two adjacent back-contact solar cells and the first busbars in the other back-contact solar cells of the two adjacent back-contact solar cells;
in the second direction, there are first gaps between the second busbar and disconnection point formed by disconnecting the first finger, and there are second gap between the first busbar and disconnection point formed by disconnecting the second finger;
at a position corresponding to each spacer region, the first ribbon or the second ribbon is cut off, in a case where the first ribbon is cut off, the first ribbon forms a first suspended segment at the spacer region, and a length of the first suspended segment is less than a width of the first gap and a width of the second gap; and
in a case where the second ribbon is cut off, the second ribbon forms a second suspended segment at the spacer region, and a length of the second suspended segment is less than the width of the first gap and the width of the second gap.

2. The battery string according to claim 1, wherein a number of the back-contact solar cells is greater than two, in two adjacent spacer regions, the first ribbon in one spacer region is cut off, and the second ribbon in an other spacer region is cut off.

3. The battery string according to claim 1, wherein the width of the first gap ranges from 0.9mm to 1.2mm; and the width of the second gap ranges from 0.9mm to 1.2mm.

4. The battery string according to claim 1, wherein in the first direction, a distance between two adjacent back-contact solar cells ranges from 0.3mm to 1.2mm.

5. The battery string according to claim 1, wherein the width of the first gap is greater than the width of the second gap.

6. The battery string according to claim 1, wherein at the position corresponding to each spacer region, a side of the first ribbon facing a light-receiving surface of the back-contact solar cell is provided with a first shielding layer, and
a side of the second ribbon facing the light-receiving surface of the back-contact solar cell is provided with a second shielding layer.

7. The battery string according to claim 6, wherein a color of the first shielding layer and a color of the second shielding layer correspond to a color of the back-contact solar cell.

8. The battery string according to claim 1, wherein an end portion of the first suspended segment and an end portion of the second suspended segment are coated with insulating coatings, and the insulating coatings wrap the end portion of the first suspended segment and the end portion of the second suspended segment.

9. The battery string according to claim 8, wherein a color of the insulating coating corresponds to the color of the back-contact solar cell.

10. A battery assembly, comprising several battery strings according to any of claims 1-9.

11. A photovoltaic system, comprising the battery assembly according to claim 10.
